(19)

Europäisches
Patentamt
European
Patent Office
Office européen
des brevets

(11) **EP 1 742 277 A2**

(12) **EUROPEAN PATENT APPLICATION**

(43) Date of publication:
**10.01.2007 Bulletin 2007/02**

(51) Int Cl.:
*H01L 31/18* *(2006.01)*

(21) Application number: **06013368.3**

(22) Date of filing: **28.06.2006**

| | |
|---|---|
| (84) Designated Contracting States:<br>**AT BE BG CH CY CZ DE DK EE ES FI FR GB GR HU IE IS IT LI LT LU LV MC NL PL PT RO SE SI SK TR**<br>Designated Extension States:<br>**AL BA HR MK YU** | (72) Inventor: **Kaneko, Kyojiro**<br>**Kainan-shi**<br>**Wakayama 642-0001 (JP)** |
| (30) Priority: **07.07.2005 JP 2005198335** | (74) Representative: **Albrecht, Thomas et al**<br>**Kraus & Weisert**<br>**Patent- und Rechtsanwälte**<br>**Thomas-Wimmer-Ring 15**<br>**80539 München (DE)** |
| (71) Applicant: **Sumco Solar Corporation**<br>**Kainan-shi**<br>**Wakayama 642-0001 (JP)** | |

(54) **Polycrystalline silicon for solar cells and method for producing the same**

(57)    In the conventional cast method, when an element causing large segregation is added to a polycrystalline silicon ingot, a concentration fluctuation becomes large depending on a region, and the yield of a portion having the target composition is low. On the contrary, the present invention enables to make the ingot having the uniform concentration. Particularly, in the case of polycrystalline silicon containing germanium and polycrystalline silicon in which gallium is added as a dopant, when the yield of a crystal having a target composition is low while conversion efficiency is high, cost reduction is not achieved in a solar cell. However, because polycrystalline silicon having the homogenous composition is easily obtained in the present invention, the high-efficiency solar cell can be produced at low costs. Therefore, polycrystalline silicon by the present invention can widely be utilized as solar-cell polycrystalline silicon containing germanium.

**Description**

BACKGROUND OF THE INVENTION

1. Field of the Invention

The present invention relates to polycrystalline silicon used for a solar cell substrate and a method for producing the polycrystalline silicon using a cooled crucible induction melting method.

2. Description of the Related Art

A silicon crystal is used as a substrate material in most (at least 90%) of the currently produced solar cells. The silicon crystal includes a single crystal and a polycrystal. Generally the solar cell having high conversion efficiency can be obtained by using the single crystal as the substrate, when the incident light energy into the solar cell is converted into electrical energy.

The high purity silicon crystal is used in order to obtain the high conversion efficiency. The low-defect-rate, dislocation-free single crystal having the same grade as the substrate material of a semiconductor integrated circuit is required in the single crystal used for the solar cell, and the single crystal is usually produced by the Czochralski method in which the single crystal is directly pulled up from molten silicon. Therefore, the production cost is increased to push up the power generation price.

On the other hand, a cast method of pouring the molten silicon in a mold to render it solidified is applied in the polycrystalline silicon. The cast method can produce the substrate material at much lower cost compared with the Czochralski method. Therefore, in order to enhance the conversion efficiency of the solar cell which is obtained by using the substrate made of the low-cost polycrystalline silicon, various studies are being made on its compositions, or the improvement of melting, the cast method, and the like of polycrystalline silicon.

Electric conductivity is required when the polycrystalline silicon is used for the solar cell substrate, so that a trace amount of dopant is added. In a P-type single crystal silicon used for the substrate of the semiconductor integrated circuit, usually boron is frequently used as the dopant. Similarly, in the solar cell, boron is frequently utilized.

In the solar-cell substrate, it is desirable that the higher conversion efficiency is obtained as the life span of a carrier generated by light becomes longer, and the carrier life span be not degraded even if the solar cell is irradiated with the strong light for a long term. However, when the boron is used as the dopant in the polycrystalline silicon, there is generated a problem that the carrier life span is shortened after the long-term use to decrease the solar-cell conversion efficiency. This is attributed to the fact that oxygen in silicon reacts with boron to reduce the effect of boron. As disclosed in Japanese Patent Application Publication No. 2001-64007, the above problem is solved by utihzing gallium as the dopant.

Usually the high purity silicon is used for the solar-cell polycrystalline silicon. On the other hand, Japanese Patent Application Publication No. 2002-289887 discloses the use of a polycrystalline alloy of silicon and germanium. In the polycrystalline alloy disclosed in Japanese Patent Application Publication No. 2002-289887, 50% germanium is added to silicon in terms of atomic concentration percentage, and the melt that is uniformly dissolved is cooled and solidified at a predetermined rate to produce the polycrystalline alloy in which a distribution ratio of the concentration is substantially even, wherein the microscopic composition of silicon ranges from 5 to 80 mole % in the crystal.

In Japanese Patent Application Publication No. 2002-289887, when the polycrystalline alloy having the microscopic concentration fluctuation as above is compared to 50 mole % silicon germanium polycrystal having no concentration fluctuation produced by a liquid phase epitaxy method, a total current value becomes larger to improve the conversion efficiency in the polycrystalline alloy having the microscopic concentration fluctuation.

In "Ge composition dependence of properties of solar cells based on multicrystalline SiGe with microscopic compositional distribution" (Wugen Pan et al., Journal of Applied Physics, Volume 96, Number 2, p.1238-1241) (hereinafter referred to as "technical report"), it is reported that the solar cell is experimentally produced to investigate the conversion efficiency with the polycrystalline alloy in which germanium ranging from 0 to 10 mole % is added to silicon and boron is doped. According to the technical report, the conversion efficiency is improved by adding the small amount of germanium. That is, the conversion efficiency becomes the maximum at about 3 mole %, the conversion efficiency is decreased when germanium is added more than 3 mole %, and the conversion efficiency becomes lower than that of the polycrystal containing only silicon when additional amount of germanium becomes 10 mole %.

Generally polycrystalline silicon is produced by the cast method. In the cast method, silicon is melted using a quartz crucible, and a necessary dopant material is added, and then the melt is solidified by pouring the melt in the graphite mold coated with silicon nitride powder that does not react with the melt. Sometimes the silicon is melted in the quartz crucible or the graphite crucible whose inner surface is protected by silicon nitride, and the melt is directly cooled and solidified.

Usually a unidirectional solidification is adopted in order to prevent internal defect caused by shrinkage cavity generated by shrinkage in the solidification, and in order to prevent the generation of crack caused by thermal stress which is easily created in the solidification and cooling process because the silicon crystal is extremely brittle.

In the unidirectional solidification, for example, in the case where the mold is used, a cooling plate which can be water-cooled is placed at a bottom of the mold, a side wall and an upper portion of the mold are kept warm or heated, and the solidification progresses upward from the bottom of the mold. In the case where the polycrystalline silicon is solidified in the crucible, the solidification is started by bringing the cooling plate into contact with the bottom of the crucible after silicon is heated and melted, and the crucible is gradually drawn downward from a heater to solidify the polycrystalline silicon upward from the bottom of the crucible.

In order to prevent contamination such as oxidation by atmospheric air, within a sealed chamber, the melting and solidification operations are performed in vacuum or an inert atmosphere at atmospheric pressure or reduced pressure. The inert atmosphere also suppresses the contamination of the chamber by SiO gas generated by reaction of the quartz crucible and the silicon melt, which is a side effect.

However, in the melting cast method in which the crucible and the mold are used, it is difficult to prevent impurity contamination caused by bringing silicon into contact with the chamber wall. On the other hand, there is developed a cooled crucible induction melting cast method in which the silicon crystal can be cast while the molten silicon is hardly brought into contact with the crucible or the mold.

For example, Japanese Patent Application Publication No. 61-52962 discloses a cooled crucible induction melting cast method. The cooled crucible induction melting cast method includes a structure in which copper plate pieces are lined to an inner peripheral side of a high-frequency induction heating coil similar to that used for melting the silicon in the crucible, comprising the copper plate pieces having good thermal conductivity that is long in the vertical direction (direction parallel to an axis of the high-frequency induction heating coil), is electrically insulated from the high-frequency induction heating coil, is electrically divided in the circumferential direction, is configured to water-cool the inside thereof, and is placed side by side.

A horizontal cross-sectional shape of the internally lined part inside the coil may be a circle or a square. A support base which can be moved downward is provided below the high-frequency induction heating coil, and the crucible comprises the internally lined coil and the support base (sometimes referred to as crucible equivalent space).

When a raw material of silicon is charged into the deemed crucible to pass the high-frequency current, silicon in the crucible can be heated and melted while the induced current insufficiently flows through the lining plate pieces, because each of the lining plate pieces is divided from each other at right angle to the induced-current generation direction. The molten silicon receives repulsive force against the lining plate pieces, namely, the inner wall of the crucible by a magnetic field generated by the induced current passed through the molten silicon and a magnetic field generated by the induced current passed through the lining plate piece, which allows silicon to be melted while the molten silicon is not in contact with the crucible.

Under the above condition, silicon is fully melted in the deemed crucible, and the support base is gradually moved downward, which allows the solidification to progress from the lower portion of the melt. The raw material is continuously charged from above the crucible in accordance with the downward movement of the support base, and the melting and the solidification are continued. Thus, the polycrystalline silicon is continuously melted and solidified by the unidirectional solidification while the molten silicon is not in contact with the wall of the crucible.

Japanese Patent Application Publication No. 63-192543 discloses an improved cast apparatus, in which the solidification is performed within the sealed chamber and the cast piece is easily withdrawn by gradually broadening the downward lining plate pieces, the more downward the broader, that come out of the heating coil at the lower end portion of the crucible. Japanese Patent Application Publication No. 2-30698 also discloses an improved technique of preventing the contact caused by melt intrusion into a gap between the copper plate pieces, and an improved technique of preventing quality degradation of the cast piece such as the crack generation and the dislocation generation in cooling the cast piece immediately after the solidification during the drawing.

## SUMMARY OF THE INVENTION

In producing the solar-cell polycrystalline silicon by the polycrystalline silicon cast method, as described above, usually the unidirectional solidification is adopted in order to prevent the generation of the internal defect in the solidification and the crack caused by the thermal stress during the cooling process.

An extremely small amount of boron or phosphorous is added as the dopant, and the dopant is added within the range in which the dopant is sufficiently soluble in the high purity silicon. Generally an element to be solid-solutioned in silicon decreases a melting point of silicon. In this case, there is generated a segregation phenomenon in which an element concentration in the melt differs from an element concentration in the solidified crystal. In the segregation phenomenon, a relationship among a temperature and the element concentrations of the melt (liquidus phase) and the solidified portion (solidus phase) can substantially be described as follows from a binary phase diagram.

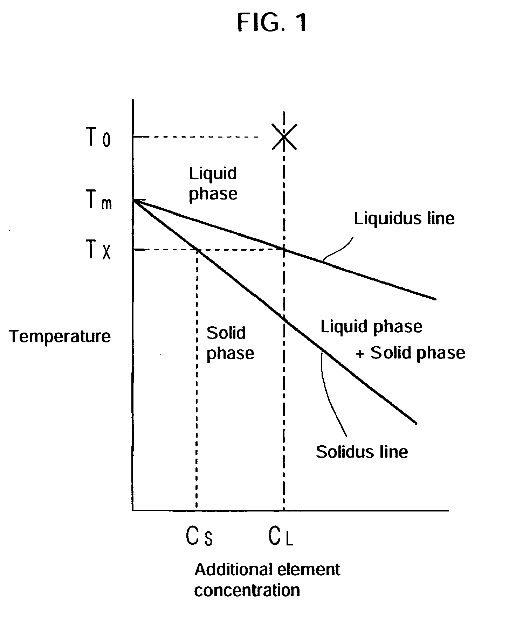

Fig. 1 shows the additional element concentration in silicon, whereas a vertical axis indicates the temperature and a horizontal axis indicates the additional element concentration. In the case where the additional element having a concentration $C_L$ (mole %) which is of a solute is evenly dissolved in the molten silicon, the solidified portion, namely, the solidus phase emerges, when the temperature of the melt which is of the even liquidus phase is decreased from a temperature To to a temperature Tx to reach a liquidus line. The solidus phase contains the $C_S$ (mole %) additional element which is of the solute.

In Fig. 1, in starting the solidification, a ratio of the additional element concentration $C_S$ of the solute in the solidus phase to the additional element concentration $C_L$ of the solute in the liquidus phase, namely, $k_0$ expressed by the following formula (4) is called equilibrium distribution coefficient or equilibrium segregation coefficient.

$$k_0 = C_S/C_L \qquad\qquad (1)$$

Because both the liquidus line and the solidus line can be approximated by straight lines under conditions that the solute concentration is low, ko becomes constant and dependent on the element. For example, $k_0$ is 0.8 for boron and $k_0$ is 0.35 for phosphorous.

For the addition of the dopant in growing the single crystal from the molten silicon by the Czochralski method, the additional element is taken into the solidified single crystal only by the amount in which the equilibrium segregation coefficient is multiplied by the additional element concentration in the melt. Therefore, it is necessary to adjust the solute element concentration in the melt in prospect of the above fact. Because the solute concentration is not largely changed in the melt in the case where the sufficient amount of melt exists, the single crystal can be grown while the dopant is substantially evenly added.

However, in the case where the polycrystal is produced by the cast method, because the unidirectional solidification is required to obtain the good ingot, the additional element concentration is largely changed according to a position of the ingot for the element in which the equilibrium segregation coefficient is largely shifted from 1. In the case where the solidification is performed upward from the bottom portion of the ingot, in Fig. 1, the solute concentration is $C_S$ mole % in the bottom portion where the solidification is started, when the temperature of the melt in which the solute concentration is $C_L$ mole % is decreased from the temperature To.

When the solidification progresses by further decreasing the temperature, the additional element concentration of the solidified solidus phase is moved downward along the solidus line to increase the additional element concentration, and the remaining additional element concentration in the melt is moved along the liquidus line to increase the additional element concentration. As a result, in the ingot, the solute concentration becomes higher at the higher position which is solidified later.

Thus, in the case where the polycrystal is produced by the cast method, it is unavoidable that the dopant concentration always fluctuates depending on the position. For boron and phosphorous, the equilibrium segregation coefficient is relatively close to "1.0" and the fluctuation in electrical conductivity exists sufficiently within an allowable range, so that the fluctuation in dopant concentration does not becomes a major problem.

However, in the case where gallium is used as the dopant, because the equilibrium segregation coefficient Ko is as small as 0.008, it is necessary to increase the dopant concentration in the melt at the start of the solidification. Therefore, the melt having the high dopant concentration remains as the solidification progresses, which increases the fluctuation in dopant concentration in the polycrystal to largely decrease a yield of the acceptable crystal portion where the target electric resistance is obtained.

In order to deal with the problem of the concentration fluctuation by the addition of gallium, Japanese Patent Application Publication No. 2005-60176 discloses a technique in which, after the raw material is melted in the crucible, the solidification is caused to progress by cooling the melt from the lower portion of the melt, and the new raw material is added to the remaining melt above the solidified part.

However, because the new raw material is added to the remaining melt above the solidified part in the crucible in which the solidification is started by cooling the melt from the lower portion of the melt after the raw material is evenly melted, it is necessary to raise the temperature in order to melt the raw material and uniformize the new raw materials and the remaining melt. This causes the already solidified portion to be re-heated and re-melted to generate the concentration fluctuation in the re-melted portion. The amount of polycrystalline silicon which can be produced at one time depends on a size of the crucible. Therefore, it is not always easy that the technique disclosed in Japanese Patent Application Publication No. 2005-60176 is applied as means for producing the polycrystalline silicon.

The silicon crystal contains the trace amount of dopant, and the fluctuation about ten times the dopant content is permitted from the viewpoint of allowable range of the resistivity fluctuation. However, in the case of the alloy in which germanium is added to silicon, it is necessary to limit the range of the fluctuation in contained germanium to a significantly narrow window in order to obtain the substrate having good performance.

Although germanium can be completely solid-solutioned to silicon, the equilibrium segregation coefficient ko of germanium is 0.43 on the Si side. For example, when the unidirectional solidification is performed to the melt in which 10 mole % germanium is evenly dissolved in the crucible or the mold by the cast method, the crystal containing 4.3 mole % germanium is first solidified. And the germanium concentration is increased as the solidification progresses. When 50% of the initial melt is solidified, the germanium concentration becomes 14.8 mole % in the remaining melt, namely, in the liquidus phase, and the germanium concentration becomes 6.4 mole % in the crystal solidified at that time.

Assuming that a boundary between the melt and the solidified crystal is a plane perpendicular to the solidification progress direction, these concentrations are average concentration in the plane. However, it is presumed that actually there are irregularities such as convex and convex in the plane and the concentration at these local portion fluctuates significantly.

When 80% of the initial melt is solidified as the solidification further progresses, the germanium concentration becomes 10.8 mole % in the crystal solidified at that time, and the germanium concentration becomes 25.0 mole % in the remaining melt. When the whole of the remaining melt is solidified at that time, the concentration fluctuates in the range of 4 to 25 mole % depending on the region in the obtained ingot.

In the alloy in which the additional element is contained much larger than the dopant, frequently the fluctuation range is narrowly limited with respect to the target concentration such that, for example, the fluctuation range is limited within $\pm$10% with respect to the target value. Therefore, the portion where the additional element concentration falls within in the allowable range is decreased in the ingot, which results in the large decrease in yield.

In view of the foregoing, it is an object of the present invention to provide solar-cell polycrystalline silicon and a method for producing the same, in which the concentration fluctuation depending on a position is decreased in the silicon polycrystal ingot to which the dopant or alloy element generating the significant segregation in the solidification is added, particularly to provide the solar-cell polycrystalline silicon and the method for producing the same , in which the concentration fluctuation of each additional element is decreased in the silicon-germanium alloy and the silicon-germanium alloy in which gallium is added as the dopant.

In order to solve the above problems, the gist of the present invention pertains to solar-cell polycrystalline silicon described in (1) to (3) and a method for producing solar-cell polycrystalline silicon described in (4) to (6).

(1) Solar-cell polycrystalline silicon containing germanium, wherein the solar-cell polycrystalline silicon is produced by continuously melting and casting the solar-cell polycrystalline silicon by a cooled crucible induction melting method.

(2) Solar-cell polycrystalline silicon described in (1), wherein a germanium content ranges from 0.1 mole % to 6.0 mole %.

(3) Solar-cell polycrystalline silicon described in (1) or (2), wherein a germanium content ranges from 0.1 mole % to 6.0 mole %, and gallium is contained as a dopant.

(4) A method for producing solar-cell polycrystalline silicon containing other element such as an alloy component and/or a dopant, wherein, given that $C_S$ mole % is a target concentration of the relevant element and ko is an equilibrium segregation coefficient of the element, the solar-cell polycrystalline silicon is continuously melted and cast by a cooled crucible induction melting method while a molten raw material is supplied such that a concentration $C_L$ mole % of the element in the silicon melt is kept by the following formula (1):

$$C_L = C_S/k_0 \qquad (1).$$

(5) A method for producing solar-cell polycrystalline silicon described in (1) or (2), wherein, given that an equilibrium segregation coefficient is set to 0.43 with respect to polycrystalline silicon in which a target germanium content is $C_S$ mole % using a cooled crucible induction melting method, the solar-cell polycrystalline silicon is continuously melted and cast while silicon and germanium which are of a raw material are supplied such that a germanium concentration in molten silicon in a crucible becomes a concentration of $C_L$ mole % given by the following formula (2):

$$C_L = C_S/0.43 \qquad (2).$$

(6) A method for producing solar-cell polycrystalline silicon described in (1) to (3), wherein, given that an equilibrium segregation coefficient is set to 0.008 with respect to germanium containing polycrystalline silicon in which a target content of dopant gallium is $D_S$ mole % using a cooled crucible induction melting method, the solar-cell polycrystalline silicon is continuously melted and cast while silicon and gallium which are of a raw material are supplied such that a gallium concentration in molten silicon in a crucible becomes a concentration of $D_L$ mole % given by the following formula (3):

$$D_L = D_S/0.008 \qquad\qquad (3).$$

According to the solar-cell polycrystalline silicon of the present invention, the ingot having the homogenous concentration can be obtained in the polycrystalline silicon ingot to which the element causing the large segregation is added. On the contrary, in the conventional cast method, the concentration fluctuates largely depending on the region, and the yield of the portion having the target composition is not large.

Particularly, in the case of polycrystalline silicon containing germanium and polycrystalline silicon in which gallium is added as the dopant, when the yield of the crystal having the target composition is low while the conversion efficiency is high, the cost reduction is not achieved in the solar cell. However, since polycrystalline silicon having the homogenous composition is easily obtained in the present invention, the high-efficiency solar cell can be produced at low cost.

BRIEF DESCRIPTION OF THE DRAWINGS

Fig. 1 is a view explaining an equilibrium segregation coefficient in a solidification process when an additional element having solubility in silicon is added;

Fig. 2 is a vertical sectional view showing a schematic structure of a cooled crucible induction melting cast apparatus;

Fig. 3 shows a change in germanium concentration in the lengthwise direction of a polycrystalline silicon ingot containing 3 mole % germanium, which is obtained in the present invention;

Fig. 4 shows a microscopic concentration distribution of the polycrystalline silicon ingot containing 3 mole % germanium; and

Fig. 5 shows an electric resistance value at each position in the length-wise direction of a germanium containing polycrystalline silicon ingot in which gallium is used as a dopant.

DESCRIPTION OF THE PREFERRED EMBODIMENT

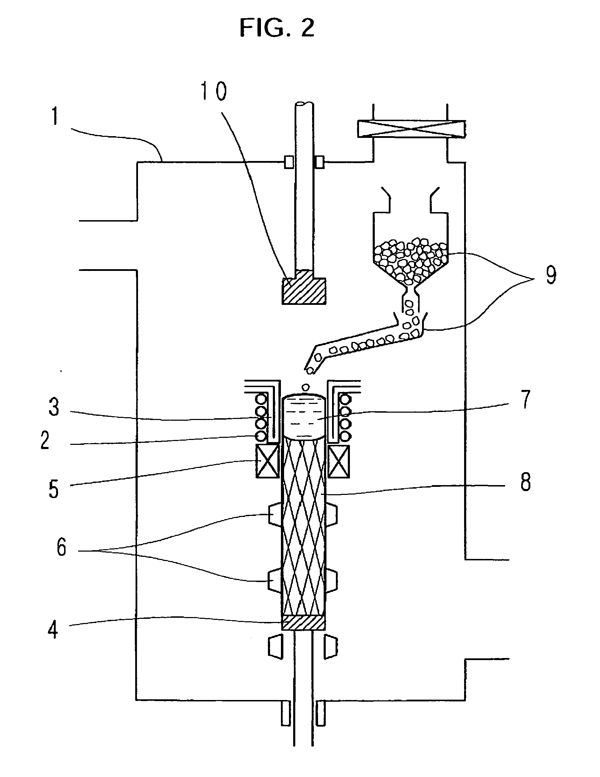

Germanium containing solar-cell polycrystalline silicon according to the present invention is produced with a cooled crucible induction melting cast apparatus. Fig. 2 is a sectional view showing a schematic structure of the cooled crucible induction melting cast apparatus.

Copper plate pieces 3 whose inside cavity is long in the vertical direction and can be water-cooled are disposed inside an induction heating coil 2 while insulated from the induction heating coil 2. The plate pieces 3 are arranged in parallel with a direction of a coil winding axis, and the plate pieces 3 are insulated from each other within the region where the induction heating coil 2 extends. A support base 4 which can be moved downward is placed at a lower end position of the induction heating coil 2. The support base may be made of polycrystalline silicon 8 having the same composition as the molten silicon. The space surrounded by the cooling plate piece 3 and the support base 4 located in the bottom portion constitutes a crucible.

An ingot, i.e., the polycrystalline silicon having the same sectional shape as the crucible is formed in an upper portion of the support base by withdrawing the ingot downwards after the melting, whereas the ingot can be withdrawn downward by a conveyance machine 6.

In order to easily withdraw the solidified ingot, the cooling plate piece 3 is preferably configured to be formed in the shape in which the more downward the larger the crucible cross-section becomes. When the ingot moves away from the induction heating coil, the ingot is rapidly cooled, excessive thermal stress is generated from a difference in shrinkage caused by temperature difference, and sometimes a crack is generated in the ingot. Therefore, a thermal insulating device 5 may be placed below the induction heating coil 2 if needed.

A raw material charging machine 9 is placed above the crucible, and the raw material charging machine 9 can charge the material into the melt in the crucible. So as not to bring the molten silicon and the high-temperature crystal into direct contact with atmosphere, these devices are placed in a sealed chamber, and the inside of the chamber is evacuated in vacuum or substituted with an inert gas or reduced-pressure inert gas atmosphere to perform the melting and casting.

When the deemed crucible is filled with the molten raw material to pass the high-frequency induced current, the material having electrical conductivity is heated and melted. In the case of high purity silicon, since the high purity silicon has relatively low electrical conductivity at low temperatures, the following method may be adopted if needed.

That is, a high-purity-graphite block 10 having the high electrical conductivity is placed on the upper surface of the raw material, the graphite block 10 is heated to melt the silicon, and the graphite block 10 is removed after the start of the melting.

In Fig. 2, molten silicon 7 in the crucible is repulsive against the cooled plate pieces 3 by the induced current, and the melting progresses while the molten silicon 7 is not in contact with the sidewall of the crucible. After the molten silicon 7 is sufficiently uniformized, when the support base 4 or the solidified ingot 8 is gradually moved downwards, the cooling is started by allowing the molten silicon 7 away from the lower end of the induction heating coil 2, and unidirectional solidification progresses toward the molten silicon in the induction heating coil 2.

Because the amount of molten silicon 7 is decreased as the support base 4 and the solidified ingot 8 are moved downwards, the corresponding amounts of silicon and additional element are supplemented from the raw material charging machine 9 located above the crucible such that a surface level of the melt is always kept constant. Thus, when the heating and melting, the withdrawing, and the raw material supply are continued, the polycrystalline silicon ingot can be continuously produced.

The polycrystalline silicon alloy according to the present invention produced with the cooled crucible induction melting cast apparatus is performed as follows.

Given that $C_S$ mole % is a content of an element contained in the polycrystalline silicon and ko is an equilibrium segregation coefficient, the molten raw material having a concentration of $C_L$ mole % determined by the following formula (1) is charged into the crucible space of the cooled crucible induction melting cast apparatus.

$$C_L = C_S/k_0 \qquad (1)$$

The molten raw material includes the polycrystalline silicon and the additional element. The metal element of itself is used as the additional element. A mother alloy in which the metal element is properly diluted by silicon may be used as the additional element if needed. In this case, when two kinds or more of the elements such as germanium and the dopant are added, the composition of the raw material is adjusted such that the concentration of each element determined by the formula (1) is obtained from target values of the elements.

The raw material is melted by passing the current through the induction heating coil, and the melt is uniformized. Then, the molten raw material is additionally supplemented from above while the ingot is withdrawn downwards. It is assumed that the additional element of $C_S$ mole % which is similar to the concentration contained in the polycrystalline silicon is mixed in the raw material to be supplemented. Because the element concentration of the polycrystalline silicon solidified and withdrawn downwards is $C_S$ mole %, when the material having the $C_S$ mole % element is supplemented to the melt to continue the melting and withdrawing, the ingot containing the $C_S$ mole % element can be continuously produced while the melt having the concentration of $C_L$ mole % is kept constant.

The supply of the raw material may intermittently be made as long as the amount of melt and the additional element concentration in the melt can substantially be kept constant.

In producing the cast polycrystalline silicon containing the element such as the dopant including gallium, arsenic, antimony, and the like, other than an alloy element such as germanium, or boron and phosphorous, each equilibrium segregation coefficient of which is smaller than 1, the cooled crucible induction melting method can effectively be utilized as a method capable of decreasing the composition fluctuation in the ingot as much as possible. Particularly the cooled crucible induction melting method is effectively used for a polycrystalline silicon alloy to which germanium is added, polycrystalline silicon in which gallium is contained as the dopant, and a germanium containing polycrystalline silicon alloy in which gallium is contained as the dopant.

When polycrystalline silicon contains germanium, the conversion efficiency is improved in the solar cell in which the germanium containing polycrystalline silicon is used. In this case, as described in the above technical report (Journal of Applied Physics, Volume 96, Number 2, p.1238-1241), when the polycrystalline silicon contains germanium in the average concentration range of 0.1 mole % to 6.0 mole %, the higher conversion efficiency is obtained compared with the high purity silicon. When the polycrystalline silicon contains germanium of about 3 mole %, the conversion efficiency becomes the maximum.

However, in order to obtain the polycrystalline silicon optimally containing 3 mole % germanium, when silicon containing 3 mole % germanium is melted in the crucible to perform the unidirectional solidification in the crucible or another mold, the germanium concentration fluctuates in the range of 1.3 mole % to 7 mole % in regions of the ingot due to the segregation, although depending on a cooling rate.

In this case, assuming that a tolerance of the germanium content for the product ranges from 2.5 to 3.5 mole %, only 40% of the ingot is obtained as the acceptable product, and the remaining 60% of the ingot becomes defective.

On the contrary, in the present invention, because germanium has the equilibrium segregation coefficient of 0.43, the following formula (2) is obtained from the above formula (1).

$$C_L = C_S/0.43 \qquad\qquad (2)$$

Assuming that $C_S$ is 3 mole %, $C_L$ becomes 7 mole %. Therefore, the molten raw material is supplied from above the cooled crucible such that the germanium concentration of 7 mole % is kept in the molten silicon in the cooled crucible, and the ingot is withdrawn downwards from the crucible while the surface level of the melt is kept constant, which allows the germanium containing polycrystalline silicon to be continuously produced with germanium average concentration of 3 mole %.

Thus, the germanium containing polycrystalline silicon having the substantially same germanium concentration throughout the length of the ingot is obtained by the method according to the present invention. Therefore, when the preferable germanium concentration is selected in using the germanium containing polycrystalline silicon for the solar-cell substrate, the yield of the substrate material having the target compositional concentration can be largely improved in the ingot.

The reason why the average content of germanium ranges from 0.1 mole % to 6 mole % is that the germanium containing polycrystalline silicon whose germanium content is below 1 mol % or above 6 mol % is equal or inferior to the polycrystalline silicon without germanium in the solar-cell conversion efficiency.

In the polycrystalline silicon used for the solar cell, in the case where boron is used as the dopant, it is known that the carrier life span is shortened after long-term use to possibly decrease the solar-cell conversion efficiency. When gallium is used as the dopant, the decrease in conversion efficiency can be suppressed.

However, when compared with boron and phosphorous usually used, germanium has the equilibrium segregation coefficient largely different from 1. Therefore, in germanium, the concentration fluctuates largely depending on the position of the ingot in the unidirectional solidification by the usual cast method.

On the contrary, when gallium is added as the dopant by exactly the same method as that in the germanium addition, the fluctuation in gallium concentration can be decreased throughout the length of the ingot. When $D_S$ is a target value of the gallium concentration, the melting is started and the molten raw material is supplied such that the gallium concentration of $D_S$ is kept constant in the melt by Formula (3).

$$D_L = D_S/0.008 \qquad\qquad (3)$$

With reference to the constant-concentration dopant contained throughout the length of the polycrystalline silicon ingot, the method in which the cooled crucible induction melting cast apparatus of the present invention is used is particularly effective one in the case where the equilibrium segregation coefficient is largely different from 1 like gallium. Further, even if the cooled crucible induction melting cast apparatus of the present invention is applied to the addition of other dopants such as boron, phosphorous, arsenic, and antimony, the ingot having the high yield and the little fluctuation for the target concentration can be obtained compared with the polycrystalline silicon ingot by the conventional cast method.

In this case, the dopant concentration in the melt and the mixture amount of the added molten raw material may be selected based on the equilibrium segregation coefficient of each element.

In the case where the polycrystalline silicon contains germanium while gallium is used as the dopant, namely, in the case where two kinds or more of the elements are contained in the polycrystalline silicon, the dopant concentration in the melt and the mixture amount of the molten raw material are selected from the equilibrium segregation coefficients of the elements with respect to the target concentrations of the elements, which allows the polycrystalline silicon to be obtained with the small fluctuation in concentration in the length-wise direction of the ingot for all the elements.

EXAMPLES

(Example 1)

The germanium containing polycrystalline silicon alloy was produced using the cooled crucible induction melting cast apparatus whose vertical sectional structure is schematically shown in Fig. 2. The cooling plate piece whose horizontal section disposed insides is configured to be a square having a side of 16 cm is arranged in the induction heating coil, and the induction heating coil has an effective height of 16 cm. The square graphite support base, whose surface is coated with silicon nitride powder, having a side of 16 cm is inserted into the lower end of the induction heating coil to form the cubic space deemed as a crucible in the induction heating coil.

The 10-kg molten raw material included 8.376-kg silicon and 1.624-kg germanium, i.e., 6.98-mole % (16.24-mass%) germanium, and the silicon and germanium were formed in a small block. The 10-kg molten raw material was charged in the space of the deemed crucible, and the sealed chamber was evacuated in vacuum to 10 Pa or less. Then, the evacuated chamber was filled with argon gas to an atmospheric pressure, and the molten raw material was melted with heating power of 250 kW at high-frequency current of 20 kHz.

After the molten raw material reached to the steady melt state, the support base was lowered at a speed of 2.0 mm/min, while the granular raw material in which 3 mole % (7.4-mass%) germanium was mixed was continuously additionally charged from above the crucible such that the surface level of the molten silicon was always kept constant in the crucible.

After the ingot length of the germanium containing polycrystalline silicon reached 200 cm, the lowering speed was decreased to the half, i.e., 1.0 mm/min. At this point, in the material charged from above, germanium was not added but only silicon was charged at a rate of 48 g/min. The support base was further lowered by 10 cm, and then the ingot was cooled. This is because the melt having the high germanium concentration remains at the end of the melting, and a portion having the high germanium concentration is formed in the polycrystalline silicon when the polycrystalline silicon is solidified, so that it is necessary that the portion having the high germanium concentration is decreased as much as possible. The ingot length was 216 cm after the cooling.

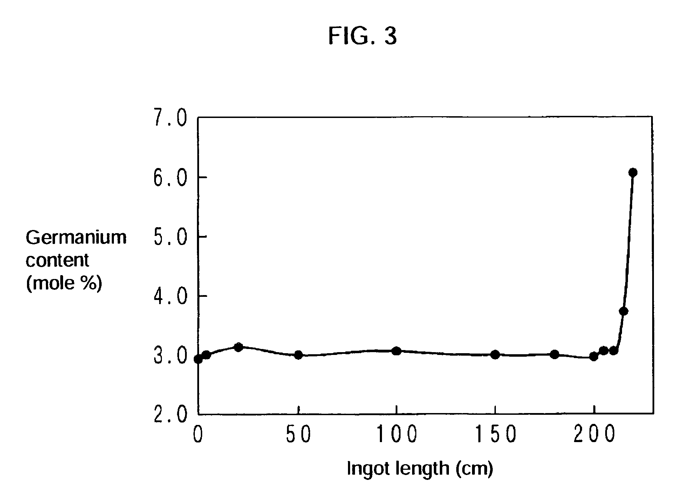

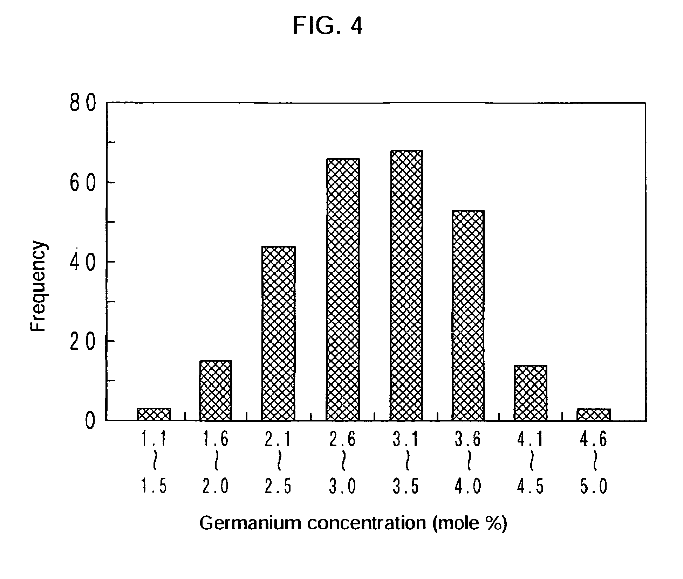

The obtained ingot was sectioned on the plane perpendicular to the lengthwise direction into plate samples to determine the average germanium concentration. Fig. 3 shows the result of the germanium average concentration. Fluorescent X-ray analysis of the germanium concentration was performed to the sample taken from the substantially central portion of the ingot at 256 intersection points with grid interval of 1 cm. Fig. 4 shows the result of a local germanium concentration distribution.

As can be seen from Fig. 3, in the germanium containing polycrystalline silicon of the present invention, the fluctuation depending on the position is extremely small in the germanium average concentration. In this case, it is found that the target polycrystalline silicon containing 3 mole % germanium was obtained in 97% of the cast polycrystalline silicon.

When an alloy containing a large amount of germanium is solidified, the concentration relationship shown in Fig. 1 holds between the liquidus phase of the melt and the solidus phase of solidified polycrystalline silicon in the ideal state in which the equilibrium state holds completely. However, actually the liquidus phase differs from the solidus phase in the diffusion rate of the element, so that the solidification cooling progresses while the element is unevenly located due to the insufficient diffusion. Further, there is the uneven temperature in both the liquidus phase and the solidus phase due to the unidirectional solidification, so that the crystallization progresses while microscopically the element concentration is not sufficiently equalized.

Therefore, conventionally the local concentration fluctuates considerably while the macroscopic average concentration is even in the whole of the cross sectional surface in the ingot. Fig. 4 shows the result of the microscopic concentration fluctuation in the present invention. As can be seen from Fig. 4, the local fluctuation in germanium content is also small against the average concentration of the ingot, and the germanium concentration is distributed in the range of 1.0 to 5.0 mole %. That is, even locally, there is no portion where the conversion efficiency is decreased.

Thus, according to the present invention, in producing the polycrystalline silicon alloy using the cooled crucible induction melting cast apparatus, the germanium containing polycrystalline silicon can stably be produced. However, the present invention is not limited to the alloy system of the germanium containing polycrystalline silicon, but the present invention can be applied to other alloy systems. For example, in producing the silicon alloy used for the silicon solar-cell substrate, the present invention can be applied to an alloy of silicon and tin and a ternary alloy of silicon, germanium, and tin. It is assumed that this is attributed to the fact that silicon, germanium, and tin belong to a quadrivalent element in a periodic table and silicon, germanium, and tin have a tetragonal diamond structure from the viewpoint of crystal structure.

(Example 2)

In the polycrystalline silicon containing 3 mole% germanium, gallium was added as the dopant using the same apparatus as Example 1.

In Example 2, the target electric resistance ranged from 1 $\Omega \cdot$cm to 2 $\Omega \cdot$cm, and the target gallium content was about 0.00002 mole %. Because the equilibrium segregation coefficient was 0.008, it is necessary that the gallium content become 0.0025 mole % in the molten state.

6.98 mole% (16.24 mass%) germanium, the 7.2 kg silicon raw material, and the 165g mother alloy containing 0.27 mass% gallium were charged as the molten raw material in the crucible space. The crucible space was evacuated in vacuum and filled with the argon gas, and the high-frequency current was passed. In this case, the graphite block whose surface was coated with the silicon nitride powder was placed above the charfed materials, and the graphite block was removed after the graphite block was red-heated to melt silicon.

After the molten raw material reached to the steady melt state, the support base was lowered at a speed of 2.0 mm/min. At the same time, the molten raw material in which silicon, germanium, and the mother alloy containing gallium were mixed in the same composition as the ingot was continuously additionally supplemented from above the crucible such that the surface level of the melt was always kept constant in the crucible.

After the ingot length of the germanium containing polycrystalline silicon reached 100 cm, the lowering speed was decreased to 1.0 mm/min. At this point, in the material charged from above, only silicon was charged at a rate of 5.9 g/min. The whole amount of remaining melt was solidified after the ingot length reached 106 cm. The ingot length was 114 cm after the cooling.

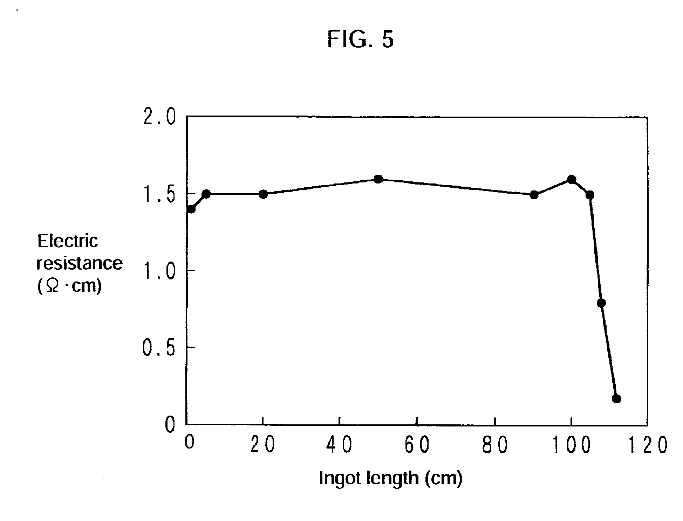

Fig. 5 shows the electric resistance at a position in the length-wise direction of the germanium containing polycrystalline silicon ingot in which gallium is used as the dopant. The obtained ingot was sectioned on the plane perpendicular to the length-wise direction into plate samples to determine the electric resistance at a position in the length-wise direction of the ingot. As can be seen from Fig. 5, in the germanium containing polycrystalline silicon in which gallium was used as the dopant, the target electrical resistance was obtained in 97% of the whole length.

As described above, according to the solar-cell polycrystalline silicon and the method for producing the same by the present invention, the ingot having the homogenous concentration can be obtained in the polycrystalline silicon ingot to which the element causing the large segregation is added. On the contrary, in the conventional cast method, the concentration fluctuates largely depending on the region, and the yield of the portion having the target composition is not large.

Particularly, in the case of polycrystalline silicon containing germanium and polycrystalline silicon in which gallium is added as the dopant, when the yield of the crystal having the target composition is low while the conversion efficiency is high, the cost reduction is not achieved in the solar cell. However, because polycrystalline silicon having the homogenous composition is easily obtained in the present invention, the high-efficiency solar cell can be produced at low cost. Therefore, polycrystalline silicon of the present invention can widely be utilized as solar-cell polycrystalline silicon containing germanium.

**Claims**

1. Solar-cell polycrystalline silicon containing germanium, **characterized in that** the solar-cell polycrystalline silicon is produced by continuously melting and casting the solar-cell polycrystalline silicon by a cooled crucible induction melting method.

2. Solar-cell polycrystalline silicon according to claim 1, **characterized in that** a germanium content ranges from 0.1 mole % to 6.0 mole %.

3. Solar-cell polycrystalline silicon according to claim 1 or 2, **characterized in that** a germanium content ranges from 0.1 mole % to 6.0 mole %, and gallium is contained as a dopant.

4. A method for producing solar-cell polycrystalline silicon according to claim 1 containing other elements such as an alloy component and a dopant, **characterized in that**, given that $C_S$ mole % is a target concentration of the element and ko is an equilibrium segregation coefficient of the element, the solar-cell polycrystalline silicon is continuously melted and cast by a cooled crucible induction melting method while a molten raw material is supplied such that a concentration $C_L$ mole % of the element in the silicon melt is kept by the following equation (1):

$$C_L = C_S/k_0 \qquad (1).$$

5. A method for producing solar-cell polycrystalline silicon according to claim 1 or 2, **characterized in that**, given that an equilibrium segregation coefficient is set to 0.43 with respect to polycrystalline silicon in which a target germanium content is $C_S$ mole % using a cooled crucible induction melting method, the solar-cell polycrystalline silicon is continuously melted and cast while silicon and germanium which are of a raw material are supplied such that a germanium concentration in molten silicon in a crucible becomes a concentration of $C_L$ mole % given by the following equation (2):

$$C_L = C_S/0.43 \qquad (2).$$

**6.** A method for producing solar-cell polycrystalline silicon according to any of claims 1 to 3, **characterized in that**, given that an equilibrium segregation coefficient is set to 0.008 with respect to germanium containing polycrystalline silicon in which a target content of dopant gallium is $D_S$ mole % using a cooled crucible induction melting method, the solar-cell polycrystalline silicon is continuously melted and cast while silicon and gallium which are of a raw material are supplied such that a gallium concentration in molten silicon in a crucible becomes a concentration of $D_L$ mole % given by the following equation (3):

$$D_L = D_S/0.008 \qquad (3).$$

## FIG. 1

# FIG. 2

# FIG. 3

## FIG. 4

FIG. 5

**EP 1 742 277 A2**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001064007 A
- JP 2002289887 A
- JP 61052962 A

- JP 63192543 A
- JP 2030698 A
- JP 2005060176 A

**Non-patent literature cited in the description**

- **WUGEN PAN et al.** *Journal of Applied Physics,* vol. 96 (2), 1238-1241

- *Journal of Applied Physics,* vol. 96 (2), 1238-1241